# EUROPEAN PATENT SPECIFICATION

(11) **EP 3 029 725 B1**
(45) Date of publication and mention of the grant of the patent: **30.10.2019**
(21) Application number: 15185025.2
(22) Date of filing: 14.09.2015
(51) Int. Cl.: H01L 23/00, H01L 21/67, H01L 21/60

(54) **CHUCK FOR COLLECTIVE BONDING OF SEMICONDUCTOR DIES, METHOD OF MAKING THE SAME AND METHODS OF USING THE SAME**
SPANNFUTTER ZUR KOLLEKTIVEN VERBINDUNG VON HALBLEITERCHIPS, VERFAHREN ZUR DESSEN HERSTELLUNG UND VERFAHREN ZUR DESSEN VERWENDUNG
PLAQUE POUR LIAISON COLLECTIVE DE PUCES SEMICONDUCTRICES, PROCÉDÉ POUR SA FABRICATION ET SON UTILISATION

(30) Priority: 01.12.2014 EP 14195646
(43) Date of publication of application: 08.06.2016
(73) Proprietor: IMEC VZW, 3001 Leuven (BE)
(72) Inventor: Wang, Teng, 3001 Leuven (BE); Daily, Robert, 3001 Leuven (BE); Rebibis, Kenneth June, 3001 Leuven (BE); Beyne, Eric, 3001 Leuven (BE)
(74) Representative: Patent Department IMEC

(56) References cited:
- US-A1- 2007 213 419
- US-A1- 2010 123 268
- US-A1- 2013 210 194
- US-A1- 2013 327 811
- WU Z ET AL: "TRANSPARENT, CONDUCTIVE CARBON NANOTUBE FILMS", SCIENCE, AAAS, AMERICAN ASSOC. FOR THE ADVANCEMENT OF SCIENCE, US, vol. 305, no. 5688, 27 August 2004 (2004-08-27), pages 1273-1276, XP008037705, ISSN: 0036-8075, DOI: 10.1126/SCIENCE.1101243

## Description

### Field of the Invention

The present invention is related to a chuck for the collective bonding of integrated circuit dies in a die-to-wafer (D2W) bonding technique, or more generally any technique wherein dies are collectively bonded to a carrier substrate.

### State of the art.

In collective bonding techniques, the process flow consists of two main steps : quick placement of dies on the target wafer or on a carrier chuck, followed by collective bonding of all the dies at wafer level. In the collective bonding step, a compliant material is needed on the chuck to compensate the stand-off height and planarity variation of the dies. Conventional material to make this "compliant chuck" is polymer-based, thus limited in operational temperature, pressure, thermal conductivity, and cycles of operation. Polymer-based materials are also difficult to be machined and integrated onto solid chucks with fine structures. Examples of prior art chucks using a compliant material and falling within the terms of the preamble of claim 1 are disclosed in US2010/0123268 A1 and US2013/0327811 A1.

### Summary of the invention

As disclosed in the appended claims, the invention is related to a compliant chuck for use in a collective D2W bonding process, to the method of producing such a chuck and to bonding methods using the chuck according to invention. The chuck of the invention is a substrate comprising on one of its flat surfaces, a number of films of carbon nanotubes, said films being deposited on a number of die placement sites. The CNT films are obtainable by growing the nanotubes on the die placement sites, i.e. the CNTs are attached to the surface of the chuck at one end and the CNTs extend outward from said surface. Preferably the CNT films are deposited in a number of recesses etched in the surface of the chuck. The recesses may have different depths, in order to compensate height differences between a plurality of dies. The CNT films are resilient and thereby give a degree of compliance to the chuck. The films may also perform an adhesive force on the dies that is high in shear direction, which allows the placement accuracy of the dies to be well maintained during bonding. The adhesion force in the normal direction is lower but still sufficient to hold the dies firmly during pre-treatments such as wet cleaning and plasma treatment. Release of the chuck from the bonded dies is easy due to the low normal adhesive force. The CNT films may be pre-compressed so as to lend a higher stability to the films.

The invention is in particular related to a chuck for the bonding of a plurality of semiconductor dies to a target wafer, said chuck comprising a plurality of die placement sites, characterized in that said die placement sites comprise on their surface a resilient film of carbon nanotubes (CNTs), said CNTs being attached to the surface of the die placement sites at one end and extending outwards from said surface.

According to an embodiment, said die placement sites are formed as recesses in a surface of the chuck. Possibly, at least two of said recesses have mutually different depths.

The chuck according to the invention may further comprise a plurality of global alignment marks for aligning the chuck to the target wafer. The chuck may comprise a plurality of local alignment marks around said die placement sites, for aligning a die with one of said die placement sites.

According to an embodiment, the carbon nanotubes of said CNT films are pre-compressed, i.e. they have a length that is shorter than the non-compressed length due to the nanotubes being permanently buckled.

The invention is equally related to a method for producing a chuck according to any one of the preceding claims, comprising the steps of :
- Providing a substrate,
- Defining a plurality of die placement sites on a surface of the substrate,
- Depositing a catalyst on said die placement sites,
- growing a film of carbon nanotubes on the catalyst.

In the above method, one or more of said die placement sites may be defined by forming recesses in said surface. The method may further comprise the step of producing global alignment marks along the circumference of the substrate. The method may also comprise the step of producing local alignment marks around said die placement sites.

According to an embodiment, the method for producing a chuck according to the invention further comprises the step of pre-compressing the carbon nanotubes of said CNT films, i.e. forming the nanotubes so that their length is shorter than the non-compressed length due to the nanotubes being permanently buckled.

The invention is equally related to a method for collective bonding of a plurality of dies to a target wafer, comprising the steps of :
- Placing the dies onto the CNT films located on the die placement sites of a chuck according to the invention, wherein said dies are temporarily attached to the chuck by an adhesive force exhibited on the dies by the CNT films,
- Aligning the chuck to the target wafer with the dies facing the target wafer,
- Bonding the dies to the target wafer,
- When the bond is established, removing the chuck by pulling the chuck away from the dies in a direction that is substantially perpendicular to the chuck.

The above method for collective bonding may further comprise the step of collectively treating the surface of the dies on the chuck by wet cleaning or plasma methods, before the steps of aligning and bonding.

The invention is equally related to a method for collective bonding of a plurality of dies to a target wafer, comprising the steps of :
- Placing the dies onto the target wafer and maintaining the dies on said wafer by a temporary attachment means,
- Aligning a chuck according to the invention to the target wafer with the CNT films facing the temporarily attached dies,
- Bonding the dies to the target wafer while exerting a pressure on said dies by means of the chuck,
- When the bond is established, removing the chuck by pulling the chuck away from the dies in a direction that is substantially perpendicular to the chuck.

### Brief description of the figures

Figures 1a to 1c illustrate the method steps for producing a chuck according to the invention.
Figure 2 illustrates a first bonding method according to the invention.
Figure 3 illustrates a second bonding method according to the invention.

### Detailed description of the invention

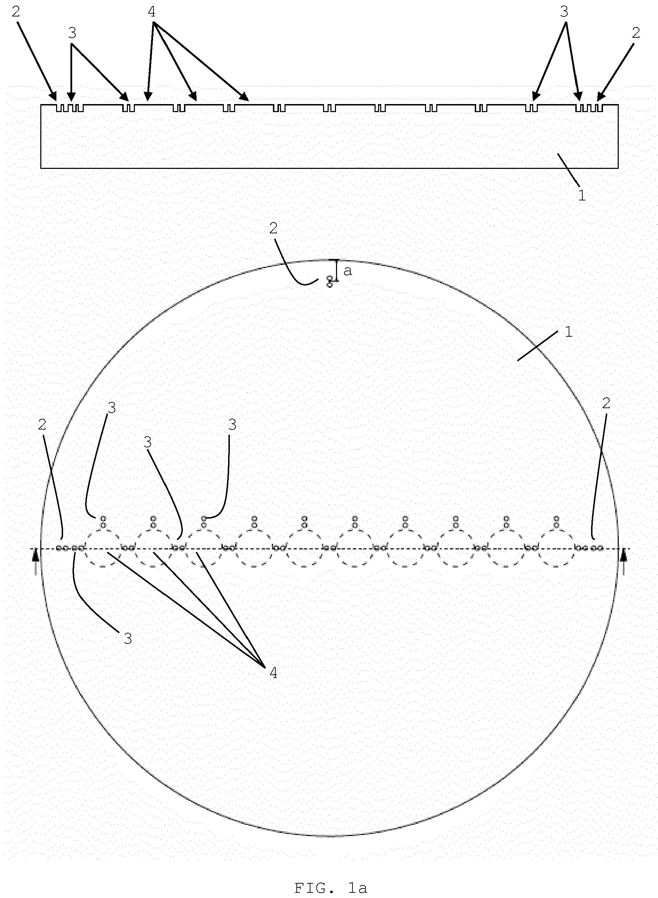

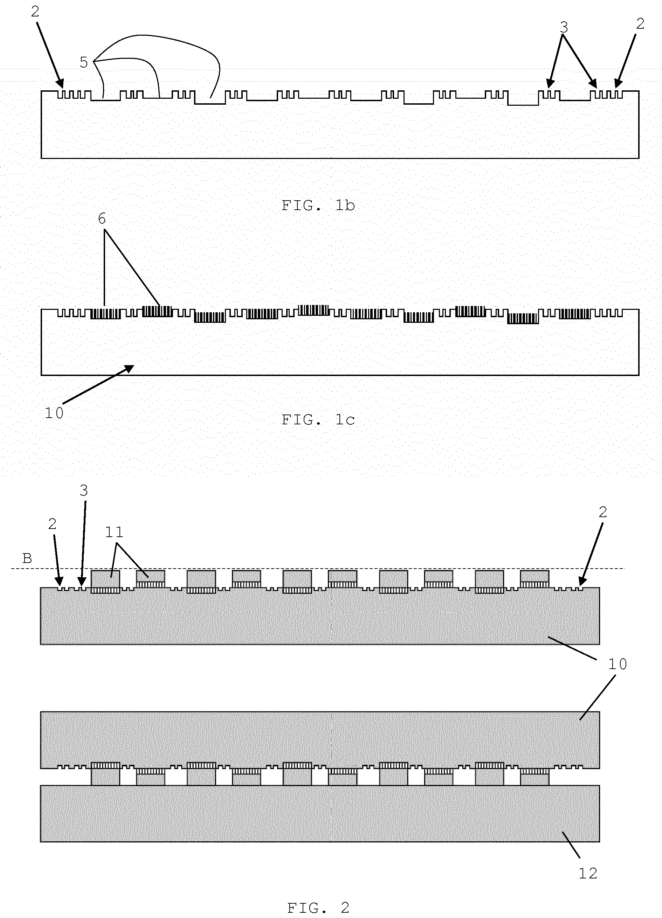

The compliant chuck according to the invention can be produced from a suitable flat substrate, for example a silicon wafer of 300 mm in diameter. Alternatively, a metal or ceramic substrate can be used. Figure 1 illustrates the fabrication steps for producing a chuck according to a preferred embodiment, starting from a circular Si-wafer. As illustrated in Figure 1a, a number of alignment marks may first be produced on the top surface of the wafer 1. Two types of marks are produced : global alignment marks 2 are made along the circumference of the substrate's top surface, at a small distance a from the substrate's edge. Local alignment marks 3 are made around a plurality of die placement sites 4, distributed over the top surface. The plane view of the substrate shown in Figure 1a illustrates only a few of the die placement sites 4, which normally cover the entirety of the surface in a predefined pattern. The alignment marks 2/3 may be produced by any suitable technique. When the substrate is a silicon wafer, the marks may be produced by lithography, i.e. by etching in the silicon with a patterned photoresist layer as a mask. Alternatively, a laser ablation technique could be used. The global and local alignment marks 2/3 are preferably produced simultaneously.

Following this, as illustrated in Figure 1b, recesses 5 are etched in the substrate at the location of the die placement sites 4. The depth of these recesses can be the same for all the placement sites, or this depth can vary between different placement sites, i.e. at least two sites have mutually different depths. A plurality of lithography steps with different masks can be used to obtain these recesses 5 with varying depths. When the recesses 5 are made, the bottom surfaces of these recesses again qualify as 'die placement sites' within the context of this description.

Finally, carbon nanotube (CNT) films 6 are selectively grown on the bottom surface of the recesses 5, as illustrated in Figure 1c. This can be done by depositing and patterning a catalyst layer on the substrate, so that the catalyst remains only on the bottom surface of each of the recesses 5. Growth of the CNT films is then established according to known CNT technology, until in each of the recesses a film is obtained consisting primarily of essentially vertically upstanding carbon nanotubes, with one end attached to the surface of the recess and the bodies of the nanotubes extending outward from said surface. The height of the tubes may be in the order of a few tens to a few hundreds of micrometers, in order to ensure sufficient resilience of the films 6 during operation. The level difference between different recesses may be anywhere between zero and a few hundred micrometers.

The preferred embodiment of the invention is a chuck 10 as produced in the above-described way, wherein at least some of the recesses 5 are at multiple mutually different levels determined on the basis of a predefined pattern of dies of different thicknesses, which are to be collectively bonded to a target substrate by means of the chuck 10. The alignment marks 3 and 2 respectively enable accurate local alignment on die level and global alignment on wafer level. The recesses 5 compensate for the height differences between the dies. The CNT films 6 provide a degree of compliance, by the fact that the vertical tubes have a degree of resilience when compressed in the longitudinal direction of the tubes. The compliance of the CNT films compensates any microscopic height differences that may not be compensated by the recesses or any non-planarities of the recesses and/or the dies. In this way, the combined effect of the recesses and the compliant CNT films results in a chuck that is suitable for use in collective bonding of dies, whilst having various advantages over known types of compliant chucks referred to above. The CNT films are capable of withstanding high operational temperature, pressure, and a high number of cycles of compression. The CNT material is also highly thermally conductive, so it can improve the thermal conduction from the chuck to the bonding interface during bonding. The CNT film can also provide a temporary adhesion which is high in shear direction but low in normal direction.

The CNT films maintain their resilience and adhesive force through many use cycles. According to a preferred embodiment, the CNT films are pre-compressed before the first use of the chuck. When the tubes are grown on the surface, they are formed as mutually parallel and essentially straight struts. When compressed, these struts buckle while remaining essentially parallel to each other, and quickly regain their original length when the compression force is removed. After a sufficiently high number of compression cycles, e.g. 1000 cycles, the compression, i.e. the buckled status of the struts, remains permanent. The result is that the tubes are permanently compressed to a thickness of for example 20% of their initial length. This phenomenon and the way in which to apply the cycles is described in US7727624. Alternatively, the permanent compression can also be achieved by applying a high force with much less cycles, e.g. 1 to a few cycles. When the film is partially pre-compressed, it is more stable during use of the chuck.

A first embodiment of a collective bonding method using a chuck according to the invention is illustrated in Figure 2. Dies 11 of different height are placed onto the CNT films of the chuck. This can be done by a known pick-and-place technique wherein the local alignment marks 3 are used for aligning each die to its respective location on the chuck. The dies are maintained on the chuck by the dry adhesive force exhibited by the CNT films. When placed on the chuck, the dies are substantially at the same upper level B given that the recesses 5 compensate for height differences between the dies and the depth of the recesses has been produced specifically as a function of a pre-defined pattern of dies with pre-defined heights. Possibly wafer level pre-treatment processes can be performed on the chuck while the dies are held by the adhesive force of the CNT films, such as wet cleaning or plasma treatments. Before bonding, the chuck is flipped and aligned to a target wafer 12, by using the global alignment marks 2 on the chuck. The chuck is then moved closer to the target wafer until the dies are in contact with their target location on the target wafer and bonding can take place. Any type of bonding technique can be applied, such as direct bonding, Cu-Cu bonding, hybrid bonding etc. When the bond is established, release of the chuck is easily done by pulling the chuck away from the dies in the direction perpendicular to the dies. As the adhesive force exhibited by the CNT films is much lower in the normal direction than in the shear direction, a low pulling force is sufficient to release the chuck.

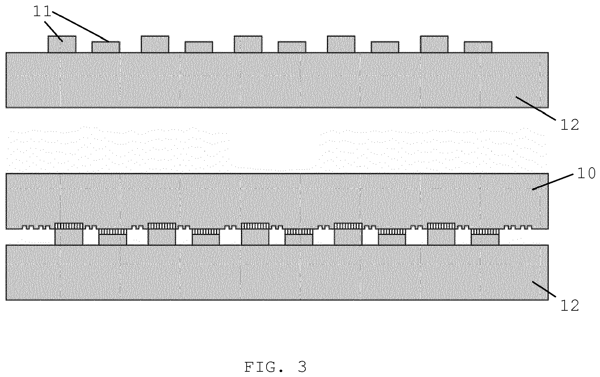

According to another embodiment, illustrated in Figure 3, the dies 11 are first placed on the target wafer 12 and temporarily maintained on their respective locations, e.g. by an underfill material. The chuck 10 is then aligned to the target wafer by using the global alignment marks 2, and pushed down onto the dies. When the permanent bond is established, release of the chuck can again be done by a small normal force. For the latter embodiment, the local alignment marks 3 are not strictly required.

When all the dies that are to be bonded have the same height, the recesses 5 can all have the same depth, as stated above, or the recess etch step may be skipped : the CNT films are then produced directly on the die placement sites 4 on the surface of the substrate 1 (Figure la).

In the above-described embodiment, the chuck 10 has the same shape as the substrate 12 onto which the dies are to be bonded. This shape need not be circular but may also be rectangular for example. Alternatively, the chuck may have a smaller surface than the surface of the substrate onto which the dies are to be bonded, in order to be able to bond groups of dies to various areas of a target substrate. The shape of the die placement sites 4/5 need not be the same for all die placement sites on the chuck. One chuck may comprise die placement sites 4/5 of different shapes, e.g. smaller and larger circles or smaller and larger squares or rectangles.

While the invention has been illustrated and described in detail in the drawings and foregoing description, such illustration and description are to be considered illustrative or exemplary and not restrictive. Other variations to the disclosed embodiments can be understood and effected by those skilled in the art in practicing the claimed invention, from a study of the drawings, the disclosure and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting the scope.

Unless specifically specified, the description of a layer being present, deposited or produced 'on' another layer or substrate, includes the options of
- said layer being present, produced or deposited directly on, i.e. in physical contact with, said other layer or substrate, and
- said layer being present, produced or deposited on one or a stack of intermediate layers between said layer and said other layer or substrate.

## Claims

1. A chuck (10) for the bonding of a plurality of semiconductor dies to a target wafer (12), said chuck comprising a plurality of die placement sites (4,5), said die placement sites comprising on their surface a resilient film (6), **characterized in that** said resilient film (6) consists of carbon nanotubes, CNTs, said CNTs being attached to the surface of the die placement sites at one end and extending outwards from said surface.

2. Chuck according to claim 1, wherein said die placement sites are formed as recesses (5) in a surface of the chuck (10).

3. Chuck according to claim 2, wherein at least two of said recesses (5) have mutually different depths.

4. Chuck according to any one of the preceding claims, further comprising a plurality of global alignment marks (2) for aligning the chuck to the target wafer (12).

5. Chuck according to any one of claims 1 to 4, further comprising a plurality of local alignment marks (3) around said die placement sites (4,5), for aligning a die (11) with one of said die placement sites.

6. Chuck according to any one of the preceding claims, wherein the carbon nanotubes of said CNT films (6) are in a permanently buckled state.

7. Method for producing a chuck (10) according to any one of the preceding claims, comprising the steps of :
• Providing a substrate (1),
• Defining a plurality of die placement sites (4,5) on a surface of the substrate,
• Depositing a catalyst on said die placement sites (4,5),
• growing a film (6) of carbon nanotubes on the catalyst.

8. Method according to claim 7, wherein one or more of said die placement sites are defined by forming recesses (5) in said surface.

9. Method according to claim 7 or 8, further comprising the step of producing global alignment marks (2) along the circumference of the substrate (1).

10. Method according to any one of claims 7 to 9, further comprising the step of producing local alignment marks (3) around said die placement sites (4,5).

11. Method according to any one of claims 7 to 10, further comprising the step of pre-compressing the carbon nanotubes of said CNT films.

12. Method for collective bonding of a plurality of dies (11) to a target wafer (12), comprising the steps of :
• Placing the dies (11) onto the CNT films (6) located on the die placement sites (4,5) of a chuck (10) according to any one of claims 1 to 6, wherein said dies are temporarily attached to the chuck by an adhesive force exhibited on the dies by the CNT films (6),
• Aligning the chuck to the target wafer with the dies facing the target wafer,
• Bonding the dies to the target wafer,
• When the bond is established, removing the chuck by pulling the chuck away from the dies in a direction that is substantially perpendicular to the chuck.

13. Method according to claim 12, further comprising the step of collectively treating the surface of the dies (11) on the chuck (10) by wet cleaning or plasma methods, before the steps of aligning and bonding.

14. Method for collective bonding of a plurality of dies (11) to a target wafer (12), comprising the steps of :
• Placing the dies (11) onto the target wafer (12) and maintaining the dies on said wafer by a temporary attachment means,
• Aligning a chuck (10) according to any one of claims 1 to 6 to the target wafer (12) with the CNT films (6) facing the temporarily attached dies (11),
• Bonding the dies to the target wafer while exerting a pressure on said dies by means of the chuck,
• When the bond is established, removing the chuck by pulling the chuck away from the dies in a direction that is substantially perpendicular to the chuck.

## Patentansprüche

1. Spannvorrichtung (10) für das Bonden einer Mehrzahl von Halbleiterchips an einen Ziel-Wafer (12), wobei die Spannvorrichtung eine Mehrzahl von Chipplatzierungsstellen (4, 5) umfasst, wobei die Chipplatzierungsstellen auf ihrer Oberfläche eine federnde Folie (6) umfassen, **dadurch gekennzeichnet, dass** die federnde Folie (6) aus Kohlenstoffnanoröhren, CNTs, besteht, wobei die CNTs an einem Ende an der Oberfläche der Chipplatzierungsstellen befestigt sind und sich von der Oberfläche nach außen erstrecken.

2. Spannvorrichtung nach Anspruch 1, wobei die Chipplatzierungsstellen als Ausnehmungen (5) in einer Oberfläche der Spannvorrichtung (10) ausgebildet sind.

3. Spannvorrichtung nach Anspruch 2, wobei zumindest zwei der Ausnehmungen (5) gegenseitig unterschiedliche Tiefen aufweisen.

4. Spannvorrichtung nach einem der vorstehenden Ansprüche, die weiter eine Mehrzahl von globalen Ausrichtungsmarkierungen (2) zum Ausrichten der Spannvorrichtung gegenüber dem Ziel-Wafer (12) umfasst.

5. Spannvorrichtung nach einem der Ansprüche 1 bis 4, die weiter um die Chipplatzierungsstellen (4, 5) herum eine Mehrzahl von lokalen Ausrichtungsmarkierungen (3) zum Ausrichten eines Chips (11) gegenüber einer der Chipplatzierungsstellen umfasst.

6. Spannvorrichtung nach einem der vorstehenden Ansprüche, wobei die Kohlenstoffnanoröhren der CNT-Folien (6) in einem dauerhaft geknickten Zustand vorliegen.

7. Verfahren zum Herstellen einer Spannvorrichtung (10) nach einem der vorstehenden Ansprüche, das die folgenden Schritte umfasst:
Bereitstellen eines Substrats (1),
Definieren einer Mehrzahl von Chipplatzierungsstellen (4, 5) auf einer Oberfläche des Substrats,
Aufbringen eines Katalysators auf die Chipplatzierungsstellen (4, 5),
Aufwachsen lassen einer Folie (6) von Kohlenstoffnanoröhren auf dem Katalysator.

8. Verfahren nach Anspruch 7, wobei eine oder mehrere der Chipplatzierungsstellen durch ein Ausbilden von Ausnehmungen (5) in der Oberfläche definiert werden.

9. Verfahren nach Anspruch 7 oder 8, das weiter den Schritt eines Herstellens von globalen Ausrichtungsmarkierungen (2) entlang des Umfangs des Substrats (1) umfasst.

10. Verfahren nach einem der Ansprüche 7 bis 9, das weiter den Schritt eines Herstellens von lokalen Ausrichtungsmarkierungen (3) um die Chipplatzierungsstellen (4, 5) herum umfasst.

11. Verfahren nach einem der Ansprüche 7 bis 10, das weiter den Schritt eines Vorkomprimierens der Kohlenstoffnanoröhren der CNT-Folien umfasst.

12. Verfahren zum kollektiven Bonden einer Mehrzahl von Chips (11) an einen Ziel-Wafer (12), das die folgenden Schritte umfasst:
Platzieren der Chips (11) auf die CNT-Folien (6), die sich auf den Chipplatzierungsstellen (4, 5) einer Spannvorrichtung (10) nach einem der Ansprüche 1 bis 6 befinden, wobei die Chips durch eine mittels der CNT-Folien (6) auf die Chips ausgeübte Haftkraft temporär an der Spannvorrichtung befestigt werden,
Ausrichten der Spannvorrichtung gegenüber dem Ziel-Wafer so, dass die Chips dem Ziel-Wafer gegenüberliegen,
Bonden der Chips an den Ziel-Wafer,
wenn der Bond hergestellt ist, Entfernen der Spannvorrichtung durch Wegziehen der Spannvorrichtung von den Chips in einer zu der Spannvorrichtung im Wesentlichen senkrechten Richtung.

13. Verfahren nach Anspruch 12, das weiter den Schritt eines kollektiven Behandelns der Oberfläche der Chips (11) auf der Spannvorrichtung (10) durch Nassreinigen oder Plasmaverfahren vor den Schritten des Ausrichtens und Bondens umfasst.

14. Verfahren zum kollektiven Bonden einer Mehrzahl von Chips (11) an einen Ziel-Wafer (12), das die folgenden Schritte umfasst:
Platzieren der Chips (11) auf den Ziel-Wafer (12) und Halten der Chips auf dem Wafer durch ein temporäres Befestigungsmittel,
Ausrichten einer Spannvorrichtung (10) nach einem der Ansprüche 1 bis 6 gegenüber dem Ziel-Wafer (12) so, dass die CNT-Folien (6) den temporär befestigten Chips (11) gegenüberliegen,
Bonden der Chips an den Ziel-Wafer, während mittels der Spannvorrichtung ein Druck auf die Chips ausgeübt wird,
wenn der Bond hergestellt ist, Entfernen der Spannvorrichtung durch Wegziehen der Spannvorrichtung von den Chips in einer zu der Spannvorrichtung im Wesentlichen senkrechten Richtung.

## Revendications

1. Plateau (10) pour le fixage d'une pluralité de puces à semi-conducteur à une plaquette cible (12), ledit plateau comprenant une pluralité de sites de placement de puce (4, 5), lesdits sites de placement de puce comprenant sur leur surface un film élastique (6), **caractérisé en ce que** ledit film élastique (6) consiste en nanotubes de carbone, NTC, lesdits NTC étant attachés à la surface des sites de placement de puce au niveau d'une extrémité particulière et s'étendant à l'extérieur de ladite surface.

2. Plateau selon la revendication 1, dans lequel lesdits sites de placement de puce sont formés comme des parties en retrait (5) dans une surface du plateau (10).

3. Plateau selon la revendication 2, dans lequel au moins deux desdites parties en retrait (5) ont des profondeurs mutuellement différentes.

4. Plateau selon l'une quelconque des revendications précédentes, comprenant en outre une pluralité de repères d'alignement global (2) pour aligner le plateau sur la plaquette cible (12).

5. Plateau selon l'une quelconque des revendications 1 à 4, comprenant en outre une pluralité de repères d'alignement local (3) autour desdits sites de placement de puce (4, 5), pour aligner une puce (11) sur l'un desdits sites de placement de puce.

6. Plateau selon l'une quelconque des revendications précédentes, dans lequel les nanotubes de carbone desdits films de NTC (6) sont dans un état gauchi de manière permanente.

7. Procédé pour produire un plateau (10) selon l'une quelconque des revendications précédentes, comprenant les étapes de :
• Fourniture d'un substrat (1),
• Définition d'une pluralité de sites de placement de puce (4, 5) sur une surface du substrat,
• Dépôt d'un catalyseur sur lesdits sites de placement de puce (4, 5),
• croissance d'un film (6) de nanotubes de carbone sur le catalyseur.

8. Procédé selon la revendication 7, dans lequel un ou plusieurs desdits sites de placement de puce sont définis en formant des parties en retrait (5) dans ladite surface.

9. Procédé selon la revendication 7 ou 8, comprenant en outre l'étape de production de repères d'alignement global (2) le long de la circonférence du substrat (1).

10. Procédé selon l'une quelconque des revendications 7 à 9, comprenant en outre l'étape de production de repères d'alignement local (3) autour desdits sites de placement de puce (4, 5).

11. Procédé selon l'une quelconque des revendications 7 à 10, comprenant en outre l'étape de précompression des nanotubes de carbone desdits films de NTC.

12. Procédé pour le fixage collectif d'une pluralité de puces (11) à une plaquette cible (12), comprenant les étapes de :
• Placement des puces (11) sur les films de NTC (6) situés sur les sites de placement de puce (4, 5) d'un plateau (10) selon l'une quelconque des revendications 1 à 6, dans lequel lesdites puces sont temporairement attachées au plateau par une force adhésive présentée sur les puces par les films de NTC (6),
• Alignement du plateau sur la plaquette cible avec les puces faisant face à la plaquette cible,
• Fixage des puces à la plaquette cible,
• Quand le fixage est établi, enlèvement du plateau en retirant brusquement le plateau des puces dans une direction qui est sensiblement perpendiculaire au plateau.

13. Procédé selon la revendication 12, comprenant en outre l'étape de traitement collectif de la surface des puces (11) sur le plateau (10) par des procédés de nettoyage humide ou au plasma, avant les étapes d'alignement et de fixage.

14. Procédé pour le fixage collectif d'une pluralité de puces (11) à une plaquette cible (12), comprenant les étapes de :
• Placement des puces (11) sur la plaquette cible (12) et maintien des puces sur ladite plaquette par un moyen d'attachement temporaire,
• Alignement d'un plateau (10) selon l'une quelconque des revendications 1 à 6 sur la plaquette cible (12), les films de NTC (6) faisant face aux puces temporairement attachées (11),
• Fixage des puces à la plaquette cible tout en exerçant une pression sur lesdites puces au moyen du plateau,
• Quand le fixage est établi, enlèvement du plateau en retirant brusquement le plateau des puces dans une direction qui est sensiblement perpendiculaire au plateau.
